# EUROPEAN PATENT APPLICATION

(11) **EP 4 372 820 A1**
(43) Date of publication of application: **22.05.2024**
(21) Application number: 22208134.1
(22) Date of filing: 17.11.2022
(51) Int. Cl.: H01L 27/06, H01L 27/085, H01L 29/10, H01L 29/417, H01L 29/778, H01L 29/423, H01L 29/06, H01L 29/20

(54) **GROUP III NITRIDE TRANSISTOR DEVICE**

(71) Applicant: Infineon Technologies Austria AG, 9500 Villach (AT)
(72) Inventor: PANDYA, Bhargav, Chandler, 85248 (US); BEER, Thomas, 87665 Mauerstetten (DE); OSTERMAIER, Clemens, 9500 Villach (AT); LEONG, Kennith Kin, 9500 Villach (AT); SANDERS, Anthony, 85622 Weißenfeld (DE)
(74) Representative: JENSEN & SON

(57) **Abstract**

In an embodiment, a Group III nitride transistor device comprises a Group III nitride-based semiconductor body comprising a Group III nitride barrier layer arranged on a Group III nitride channel layer and forming a heterojunction therebetween capable of supporting a two-dimensional charge gas. A switching Group III nitride transistor device and a current sense Group III nitride transistor device are formed in the Group III nitride-based semiconductor body. The current sense Group III nitride-based transistor device is electrically insulated from the switching Group III nitride transistor device by local interruption of the two-dimensional charge gas.

## Description

### BACKGROUND

To date, transistors used in power electronic applications have typically been fabricated with silicon (Si) semiconductor materials. Common transistor devices for power applications include Si CooIMOS^{®}, Si Power MOSFETs, and Si Insulated Gate Bipolar Transistors (IGBTs). More recently, silicon carbide (SiC) power devices have been considered. Group III-N semiconductor devices, such as gallium nitride (GaN) devices, are now emerging as attractive candidates to carry large currents, support high voltages and to provide very low on-resistance and fast switching times

In some applications it is desirable to determine the current that is being transmitted through the device, for example to avoid failure of the device caused by undue power dissipation. In half bridge or full bridge applications, in which two or more transistor devices are coupled in series, it may be desirable to determine the current that is being carried in one switch before the other switch is turned on in order to avoid shoot through, for example. US 2006/081985 A1 discloses a Group III nitride power semiconductor device that includes a current sense electrode.

The current I_{L} in a transistor device can be sensed using a second smaller transistor device that is coupled in parallel with the transistor device, the smaller transistor device carrying a sense current Is. The ratio between I_{L} and is is known as the K_{ILIS} factor or ratio (load current to sense current ratio) which quantifies the accuracy of the current sensing. If the K_{ILIS} factor of a particular current sensing transistor device is known, then measurement of the sensing current may be used along with the K_{ILIS} factor to determine the amount of load current flowing through the main switching transistor device. Ideally the relationship between the sense current is and the load current I_{L} is linear and their ratio is constant and equal to K_{ILIS}(ideal). However, in practice, the ratio differs from the ideal ratio. Thus, the degree of accuracy of a load current measurement is dependent upon the degree of accuracy to which a current sensing transistor device actually produces a specified K_{ILIS} factor.

It is, therefore, desirable to further improve the accuracy of current sensing in Group III nitride transistor devices.

### SUMMARY

According to the invention, a Group III nitride transistor device is provided that comprises a Group III nitride-based semiconductor body or substrate that comprises a Group III nitride barrier layer arranged on a Group III nitride channel layer which forms a heterojunction between the Group III nitride barrier layer and the Group III nitride channel layer that is capable of supporting a two-dimensional charge gas. A switching Group III nitride transistor device and a current sense Group III nitride transistor device are formed in the Group III nitride-based semiconductor body. The current sense Group III nitride-based transistor device is electrically insulated from the switching Group III nitride transistor device by local interruption of the two-dimensional charge gas.

This arrangement provides a more accurate measurement of the current carried by the Group III nitride transistor device as it avoids resistance spreading which can lead to the value of the measured sense current inaccurately reflecting the actual current carried by the Group III nitride transistor device. In other words, by locally interrupting the two-dimensional charge gas and electrically insulating the channel of the current sense Group III nitride-based transistor device from the channel of the switching Group III nitride transistor device, any difference in the actual K_{ILIS} factor from the expected K_{ILIS} factor is reduced or even eliminated. Therefore, a Group III nitride transistor device with more accurate current sensing is provided.

The current sense Group III nitride-based transistor device and the switching Group III nitride transistor device are formed in a common Group III nitride substrate and can be considered to be monolithically integrated into the Group III nitride substrate which comprises the Group III nitride barrier layer arranged on the Group III nitride channel layer. The Group III nitride barrier layer and the Group III nitride channel layer have different compositions and different bandgaps and the two-dimensional charge gas is formed by piezoelectric and spontaneously polarisation at the interface, i.e. heterojunction, between the Group III nitride barrier layer and the Group III nitride channel layer. The Group III nitride channel layer may be formed of GaN and the Group III nitride barrier layer be formed of AlGaN.

A separate two-dimensional charge gas, for example a two-dimensional electron gas (2DEG) or two-dimensional hole gas (2DHG) is provided for each of the current sense Group III nitride-based transistor device and the switching Group III nitride transistor device, since the current sense Group III nitride-based transistor device is electrically insulated from the switching Group III nitride transistor device by local interruption of the two-dimensional charge gas.

In some embodiments, the two-dimensional charge gas is locally interrupted by an isolation region in order to electrically insulate the current sense Group III nitride-based transistor device from the switching Group III nitride transistor device.

In some embodiments, the isolation region has the form of a closed ring that laterally surrounds the current sense Group III nitride transistor device. The closed ring is continuous and uninterrupted.

In some embodiments, the isolation region comprises an implanted region or damaged region. The implanted region comprises a disrupted and damaged crystal structure and, therefore, a non-epitaxial crystal structure. And is distinguishable from the regions of the Group III nitride substrate outside of the damaged region.

The Group III nitride-based semiconductor body comprises a first major surface and a second major surface that opposes the first major surface. The isolation region may be a buried region, i.e. it does not extend to the first major surface or to the second major surface. The buried region extends across the interface between the Group III nitride channel and barrier layers in order that the implanted region interrupts the two-dimensional charge gas that is supported at the interface and electrically insulates the current sense Group III nitride-based transistor device from the switching Group III nitride transistor device. The buried implanted region comprises a disrupted and damaged crystal structure which is non-epitaxial and, therefore, distinguishable from the regions of the Group III nitride substrate outside of the implanted region.

In some embodiments, the isolation region has a depth from the first surface that is greater than a depth of the heterojunction from the first surface. In some embodiments, the isolation region comprises a damaged region that extends into the Group III nitride body from the first major surface, through the Group III nitride barrier layer and into the Group III nitride channel layer in order to locally interrupt the two-dimensional charge gas.

In some embodiments, the isolation region comprises a trench extending into the first surface that comprises insulating material. The trench interrupts the two-dimensional charge gas and electrically insulates the current sense Group III nitride-based transistor device from the switching Group III nitride transistor device.

In some embodiments, the isolation region has a depth from the first surface that is greater than a depth of the heterojunction from the first surface. For example, the trench may have a base and side walls that extend from the base to the first major surface. The side walls extend through the heterojunction so that the base of the trench is arranged in the lower of the two layers forming the heterojunction, i.e. in the Group III nitride channel layer.

In some embodiments, the switching Group III nitride transistor device comprises a plurality of active transistor cells and the current sense Group III nitride transistor device comprises at least one sense transistor cell. Each active transistor cell comprises a source finger, a gate finger and a drain finger on the first major surface, the gate finger being laterally positioned between the source finger and the drain finger. Each sense transistor cell comprises sense source finger, a sense gate finger and a second drain finger on the first major surface, the sense gate finger being laterally positioned between the sense source finger and the sense drain finger.

The ratio of the number of sense transistor cells and the number of active transistor cells may be selected to provide a desired K_{ILIS} ratio. The K_{ILIS} ratio may lie in the range or 1 : 2000, 1 : 5000 or 1 :10,000 for example. Alternatively, or in addition, the ratio of the active area of the current sense transistor device and the active area of the switching transistor device may be selected so as to provide a desired K_{ILIS} ratio.

Alternatively, or in addition, the length of the sense source finger and sense drain finger may be selected so as to provide a desired K_{ILIS} ratio.

In some embodiments, the sense source finger has a length that is aligned with a length of one of the active source fingers of the plurality of active transistor cells and is spaced apart from that active source finger by a first gap. A portion of the isolation region is positioned in the first gap.

This arrangement provides a compact configuration for integrating the sense transistor cell(s) into the configuration of the active transistor cells.

In some embodiments, the Group III nitride transistor device further comprises a source metallization finger arranged on the source finger of each active transistor cell and a sense source metallization finger arranged on the sense source finger. The source metallization fingers and the sense source metallization finger are spaced apart from one another and electrically insulated from one another. The active source finger and the sense source finger are electrically insulated from one another by an intervening portion of the isolation region.

In some embodiments, the sense gate finger is integral with one of the gate fingers of the plurality of transistor cells of the switching Group III nitride transistor device. For example, the sense gate finger may be formed by a portion of one of the active gate fingers. In other words, the sense gate finger is integral with one of the active gate fingers. This provides a compact arrangement and also enables the sense gate finger to be switched at the same time and under the same conditions as the active gate fingers. This improves the accuracy of the current sensing.

In some embodiments, the sense drain finger has a length that is aligned with a length of one of the drain fingers of the plurality of transistor cells and spaced apart from that drain finger by a second gap. A portion of the isolation region is positioned in the second gap. The active drain finger and the sense drain finger are electrically insulated from one another by the intervening portion of the isolation region.

In some embodiments, the sense drain finger is electrically connected to the drain finger of the plurality of transistor active cells of the switching Group III nitride transistor device by a drain metallization finger that extends over the second gap. In some embodiments, the drain metallization finger is arranged on one of the drain fingers of the plurality of transistor active cells of the switching Group III nitride transistor device and on the sense drain finger of the current sense Group III nitride transistor device and also extends between this drain finger of the switching Group III nitride transistor device and the sense drain finger.

The electrical connection between the sense gate finger and the active gate finger is positioned in a different plane from the electrical connection between the sense drain finger and the active drain finger. In some embodiments, the common sense and active gate finger is arranged directly on the first major surface of the Group III nitride substrate and the drain metallization finger is arranged in a plane above the first major surface of the Group III nitride substrate.

In some embodiments, the Group III nitride transistor device further comprises a source pad, a drain pad, a gate pad and a current sense pad. The source fingers of the switching Group III nitride transistor device are electrically coupled to the source pad and the sense source fingers of the current sense Group III nitride transistor device are electrically coupled to the current sense pad. The gate fingers of the switching Group III nitride transistor device and the sense gate fingers of the current sense Group III nitride transistor device are electrically coupled to the gate pad and the drain fingers of the switching Group III nitride transistor device and the sense drain fingers of the current sense Group III nitride transistor device are electrically coupled to the drain pad.

In some embodiments, the switching Group III nitride transistor device and the current sense Group III nitride-based transistor device are each HEMT (High Electron Mobility Transistor) devices.

In some embodiments, the Group III nitride channel layer is formed of GaN and the Group III nitride barrier layer is formed of AlGaN, i.e. AlₓGa₍₁₋ₓ₎N, where 0 < x < 1.

In some embodiments, the Group III nitride substrate further comprises a base substrate and a Group III nitride buffer structure on the base substrate, the Group III nitride channel layer is arranged on the Group III nitride buffer structure and the Group III nitride barrier layer is arranged on the Group III nitride channel layer. In some embodiments, the Group III nitride barrier layer forms the first major surface of the Group IIII nitride substrate.

The base substrate may comprise an upper or growth surface which is capable of supporting the epitaxial growth of one or more Group III nitride-based layers. In some embodiments, the base substrate is a foreign substrate, i.e. is formed of a material other than Group III nitride materials that includes the upper or growth surface which is capable of supporting the epitaxial growth of one or more Group III nitride-based layers. The base substrate may be formed of silicon and may be formed of monocrystalline silicon or an epitaxial silicon layer, for example, or sapphire.

In some embodiments, the Group III nitride-based semiconductor substrate may further include a Group III nitride back barrier layer. The Group III nitride channel layer is formed on the back barrier layer and forms a heterojunction with the Group III nitride back barrier layer and the Group III nitride barrier layer is formed on channel layer. The back barrier layer has a different bandgap to the channel layer and may comprise AlGaN, for example. The composition of the AlGaN of the back barrier layer may differ from the composition of the AlGaN used for the barrier layer.

A transition or buffer structure for a silicon base substrate may comprise a AIN starting layer on the silicon substrate followed by a AlₓGa₍₁₋ₓ₎N layer sequence, whereby the Al content of about 50-75% is decreased down to 10-25% before the GaN layer or AlGaN back barrier, if present, is reached. Alternatively, a superlattice buffer can be used which may comprise an AIN starting layer on the silicon base substrate, a sequence of AIN and AlₓGa₍₁₋ₓ₎N pairs is grown. Alternatively, an AlₓGa₍₁₋ₓ₎N layer sequence as described above can be used in combination with the above mentioned superlattice.

Both the switching Group III nitride device and the current sense transistor device may be a depletion mode device or an enhancement mode device.

In some embodiments, the current ratio between the switching Group III nitride transistor and the current sense Group III nitride transistor (KILIS) is 5000 or more, or 10000 or more.

In some embodiments, the current sense Group III nitride transistor device comprises a single sense source finger, a single sense gate finger and a single sense gate finger and the length of the sense source finger and sense drain finger is selected so as to provide a current ratio of 5000 or more, or 10000 or more.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a diagram of a transistor device with current sense functionality.
Figure 2 illustrates a cross-sectional view of a Group III nitride transistor device with a current sense functionality.
Figure 3A illustrates a cross-sectional view, Figure 3B illustrates a top view, Figure 3C a cross-sectional view along line A-A and Figure 3D a cross-sectional view of along the line B-B of a Group III nitride transistor device with current source functionality.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode device, such as a high-voltage depletion-mode transistor, has a negative threshold voltage which means that it can conduct current at zero gate voltage. These devices are normally on. An enhancement-mode device, such as a low-voltage enhancement-mode transistor, has a positive threshold voltage which means that it cannot conduct current at zero gate voltage and is normally off. An enhancement-mode device is not limited to low voltages and may also be a high-voltage device.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐPbN_{(1-a-b)}), for example. Aluminum gallium nitride and AlGaN refers to an alloy described by the formula AlₓGa₍₁₋ₓ₎N, where 0 < x < 1.

Current sensing of the current in a transistor device used for switching a load may be used for many applications including but not limited to motor drives, charger-adaptors etc. Current sensing allows the load current conditions to be measured.

Conventionally, current sensing is realized using a shunt resistor and the voltage drop across this resistor determines the current level. Current sensing may be provided by use of a K_{ILIS} cell which determines the mirror transformation of currents between load cell and source cell. Depending upon K_{ILIS} ratio, sense currents can be varied in the form of 1:2k, 1:5k or 1:10k

Integrated current sensing using a K_{ILIS} cell in GaN technology is provided herein. A negative feedback loop can also be helpful as a controller (Gate driver) can limit the current through the device and provide over current protection.

It was observed that in devices formed form Group III nitride materials, the K_{ILIS} is not a simple function of the ratio of the dimensions of the current sense and main switch widths. When the electrical separation between the current sense and the main switch is of a similar dimension to the current sense, the error was found to become extremely large, i.e. 6k verses 10k. This limits the maximum K_{ILIS} to an unacceptably low value compared to the desired value.

Electrical Isolation between "source" of the switching transistor device and "source sense" of the sense transistor device has been found to influence the accuracy of current sensing in Group III nitride technology. Such electrical isolation may be used to mitigate or eliminate a difference between the between measured and estimated values of the sensed current which is thought to result from the phenomenon of resistance spreading.

A Group III nitride transistor device is a depletion mode device that is Normally-ON unless further measures are taken. In some embodiments, the Group III nitride transistor device comprises a recessed gate and/or a p-doped Group III nitride layer between the gate metal and the Group III nitride substrate in order to form an enhancement mode device that is normally off.

It is thought that current spreading causes the mismatch in measured vs estimated K_{ILIS} values, If the source and current sense fingers are within the same non-isolated region. It is proposed to use a completely isolated "Sense finger" for the implementation of a current sense device in a common Group III nitride substrate with a switching Group III nitride transistor device in order to avoid any current spreading and to provide a transistor device in which the actual K_{ILIS} ratio that is achieved is more similar to the expected value.

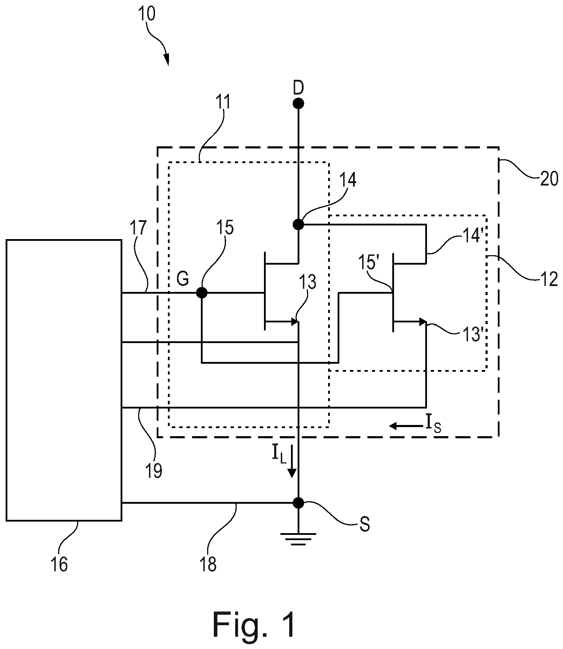

Figure 1 illustrates a diagram of a transistor device 10 with current sense functionality. The transistor device 10 comprises a switching Group III nitride transistor device 11 and a current sense Group III nitride device 12. The current sense Group III nitride transistor device 12 and is coupled in parallel with the switching Group III nitride transistor 11.

The switching Group III nitride transistor device 11 comprises a source 13, a drain 14 and a gate 15 and the current sense Group III nitride transistor device 12 comprises a source 13', a drain 14' and a gate 15'. The drain 14' of the current sense Group III nitride transistor device 12 is electrically coupled to the drain 14 of the switching Group III nitride transistor device 11 and the gate 15' of the current sense Group III nitride transistor device 12 is electrically coupled to the gate 15 of the switching Group III nitride transistor device 11. The source 13 of the switching Group III nitride transistor device 11 is electrically coupled to ground in this embodiment. The source 13' of the current sense Group III nitride transistor 12 is electrically separated from the source 13 of the switching Group III nitride transistor device 11.

Figure 1 also shows a driver 16 which is electrically coupled to the gate 15 of the switching Group III nitride device 11 and consequently also to the gate 15' of the current sense Group III nitride transistor 12 by a connection 17. The driver 16 is also electrically coupled to the source 13 of the switching Group III nitride transistor device 11 by a connection 18 and to the source 13' of the current sense Group III nitride transistor device 12 by connection 19 which is electrically separate from the connection 18 and from the source 13 of the switching Group III nitride transistor device 11.

The switching Group III nitride transistor device 11 and the current sense Group III nitride transistor device 12 are integrated in a common Group III nitride-based substrate which is indicated in Figure 1 by the box 20. The switching Group III nitride transistor device 11 is used for switching a load current and the current sense Group III nitride transistor device 12 is used to sense the current flowing though the switching Group III nitride transistor device 11.

The Group III-nitride-based substrate 20 comprises a Group III nitride barrier layer arranged on a Group III nitride channel layer. The Group III nitride barrier layer and the Group III nitride channel layer have different compositions and bandgaps so that a heterojunction is formed at the interface between the Group III nitride barrier layer and the Group III nitride channel layer which is capable of supporting a two-dimensional charge gas. The two-dimensional charge gas is formed by piezoelectric and spontaneous polarization and may comprise electrons (2DEG) or holes (2DHG).

For example, the Group III nitride channel layer may be formed of gallium nitride and the Group III nitride barrier layer formed of aluminium gallium nitride.

The current I_{L} in the switching Group III nitride transistor device 11 is sensed using the second current sense Group III nitride transistor device 12 which is smaller than the switching Group III nitride transistor device 11 and which is coupled in parallel with the switching Group III nitride transistor 11. The smaller current sense Group III nitride transistor device 12 carries a sense current is which is smaller than Is. The ratio between I_{L} and is is known as the K_{ILIS} factor or ratio which quantifies the accuracy of the current sensing. The K_{ILIS} ratio may lie in the range of 1 to 2000, 1 to 500 or 1 to 10,000, for example. The expected K_{ILIS} ratio may be set by setting the number of transistor cells and/or the active area and/or the length of the source and drain fingers of the current sense Group III nitride transistor device 12 to be smaller than the respective number of transistor cells and/or the active area and/or the length of the source and drain fingers of the switching Group III nitride transistor device 11.

In order to increase the accuracy of the current sensing by reducing any difference, in particular by reducing any decrease in the actual K_{ILIS} ratio from the expected K_{ILIS} ratio, according to exemplary embodiments described herein, the current sense Group III nitride transistor device 11 is electrically separated from the switching Group III nitride transistor device 12. The current sense Group III nitride transistor device 12 may be electrically insulated from the switching Group III nitride transistor device 11 by local interruption of the two-dimensional charge gas which is formed at the heterojunction.

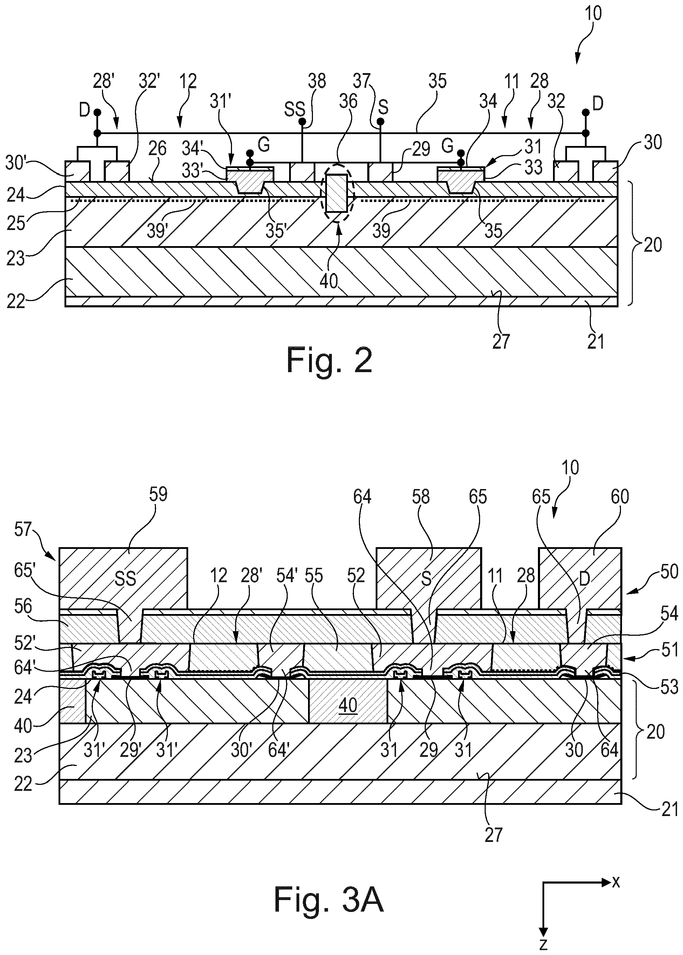

Figure 2 illustrates a cross-sectional view of a Group III nitride transistor device 10 comprising a current sense Group III nitride transistor device 12 and a switching Group III nitride transistor device 11 integrated into a common Group III nitride substrate 20. The Group III nitride transistor device 10 includes electrical isolation between the current sense Group III nitride transistor device 11 from the switching Group III nitride transistor device 12.

The Group III nitride substrate 20 of the Group III nitride transistor device 10 comprises a multilayer structure that is arranged on a base substrate 21. The Group IIII nitride substrate 20 comprises a buffer structure 22 on the base substrate 21, a Group III nitride, e.g. GaN, channel layer 23 on the buffer structure 22 and a Group III nitride, e.g. AlGaN, barrier layer 24 on the GaN channel layer 23 which forms a heterojunction 25 at the interface formed between the GaN channel layer 23 and the AlGaN barrier layer 24 which supports a two-dimensional charge gas such as a two-dimensional electron gas (2DEG). In this embodiment, the AlGaN barrier layer 24 forms the upper surface 26 of the Group IIII nitride substrate 20.

The base substrate 21 includes an upper or growth surface 27 which is capable of supporting the epitaxial growth of one or more Group III nitride-based layers. In some embodiments, the base substrate 21 is a foreign substrate, i.e. is formed of a material other than Group III nitride materials that includes the upper or growth surface 27 which is capable of supporting the epitaxial growth of the Group III nitride-based layers 22, 23, 24. The base substrate 21 may be formed of silicon and may be formed of monocrystalline silicon or an epitaxial silicon layer, for example, or sapphire.

In some non-illustrated embodiments, the Group III nitride-based semiconductor substrate 20 may further include a back barrier layer located between the buffer layer 22 and the channel layer 23. The channel layer 23 is formed on the back barrier layer and forms a heterojunction with the back barrier layer and the barrier layer 24 is formed on channel layer 23. The back barrier layer has a different bandgap to the channel layer 23 and may comprise AlGaN, for example. The composition of the AlGaN of the back barrier layer may differ from the composition of the AlGaN of barrier layer 24.

A typical transition or buffer structure 22 for a silicon base substrate includes a AIN starting layer, which may have a thickness of several 1 00nm, on the silicon substrate followed by a AlₓGa₍₁₋ₓ₎N layer sequence, the thickness again being several 100nm's for each layer, whereby the Al content of about 50-75% is decreased down to 10-25% before the GaN layer or AlGaN back barrier, if present, is grown. Alternatively, a superlattice buffer can be used. Again, an AIN starting layer on the silicon substrate is used. Depending on the chosen superlattice, a sequence of AIN and AlₓGa₍₁₋ₓ₎N pairs is grown, where the thickness of the AIN layer and AlₓGa₍₁₋ₓ₎N is in the range of 2-25nm. Depending on the desired breakdown voltage the superlattice may include between 20 and 100 pairs. Alternatively, an AlₓGa₍₁₋ₓ₎N layer sequence as described above can be used in combination with the above mentioned superlattice.

The switching Group III nitride transistor 11 is formed in a first region and the current sense Group III nitride transistor 12 is formed in a second region of the Group III nitride substrate 20 that is positioned laterally adjacent the first region. The switching Group III nitride transistor device 11 comprises a plurality of transistor cells 28, of which one can be seen in the cross-sectional view of figure 2. Each transistor cell 28 comprises a source finger 29, a drain finger 30 and a gate finger 31 which are arranged laterally adjacent one another on the first major surface 26 of the Group III nitride body 20 with the gate finger 31 being arranged laterally between and laterally spaced apart from the source finger 29 and the drain finger 30. The source finger 29, the drain finger 30 and the gate finger 32 each have an elongate stripe -like structure and extend substantially parallel to one another into the plane of the drawing.

In the embodiment illustrated in figure 2, the drain finger 30 further comprises a p-doped Group III nitride region 32 which is arranged on the first major surface 26 and laterally located between the gate finger 31 and the drain finger 30. The p-doped Group III nitride region 32 is electrically coupled to the drain finger 30 and is spaced apart from the gate finger 31. In other embodiments, the p-doped Group III nitride region 32 is omitted.

In the embodiment illustrated in figure 2, the gate finger 31 comprises a p-doped Group III nitride layer 33 which is positioned on the first major surface 26 and a gate metal layer 34 which is arranged on the p-doped Group III nitride layer 33. In this embodiment, the gate finger 31 has a recessed structure and the p doped Group III nitride layer 33 is arranged in the recess 35 formed in the Group III nitride barrier layer 24. The recessed gate structure and/or p-doped Group III nitride layer 33 may be used to deplete the two-dimensional charge gas at a region under the gate finger 21 so that in this embodiment, the Group III nitride switching Group III nitride transistor device 11 is an enhancement mode device which is normally off.

The current sense Group III nitride transistor device 12 also comprises at least one transistor cell 28' which has the same structure in cross-section as the active transistor cells 28 of the switching Group III nitride transistor 11. Each current sense transistor cell 28' comprises a sense source finger 29', a sense drain finger 30' and a sense gate finger 31' arranged on the first major surface 26 with the sense gate finger 31' arranged laterally between and spaced apart from the sense source 29' and the sense drain finger 30'. In this embodiment, the sense drain finger 30' also comprises a p doped Group III nitride layer 32' which is electrically connected to the sense drain finger 30' and spaced laterally spaced apart from the gate finger 31'. The gate finger 31' also comprises a recessed structure with doped Group III nitride layer 33' arranged in the recess 35' and on the first major surface 26 and a metal layer 34' arranged on the p-doped Group III nitride layer 33'.

The sense drain finger 30' is electrically connected to the drain finger 30 by an electrical connection 35 and the sense gate finger 31' is electrically connected to the gate finger 31 by electrical connection 36. The source 29 of the switching Group III nitride transistor 11 has a first electrical connection 37 and the sense source finger 29' has a second electrical connection 38 which is separate from the first electrical connection 37.

The two-dimensional charge gas which is formed at the heterojunction 35 is formed by spontaneous and piezoelectric polarisation. Consequently, in an enhancement mode device, the two-dimensional charge gas, which is indicated in the drawing by the dotted line 39, is formed throughout the area of the heterojunction formed between the channel layer 23 and barrier layer 24 of the Group III nitride substrate 20 except under the gate finger 31 of the switching Group III nitride transistor 11 and under the gate finger 31' of the current sense Group III nitride transistor 12. In embodiments, in which the switching Group III nitride transistor device 11 and the current sense Group III nitride transistor 12 are depletion mode devices, the two-dimensional charge gas is formed throughout the area of the heterojunction formed between the channel layer 23 and barrier layer 24 of the Group III nitride substrate 20 including under the gate finger 31 of the switching Group III nitride transistor 11 and under the gate finger 31' of the current sense Group III nitride transistor 12. In the Group III nitride transistor device 10, the two-dimensional charge gas 39 is, therefore, also formed at regions of the Group III nitride substrate 20 that are laterally between or outside, for example, at the periphery, of the switching Group III nitride transistor device 11 and the current sense Group III nitride device 12.

In order to provide the electrical insulation of the current sense Group III nitride transistor 12 from the switching Group III nitride transistor device 11, an isolation region 40 is introduced into the Group III nitride substrate 20 which interrupts the two-dimensional charge gas 39 locally at a position which is laterally between the current sense Group III nitride transistor 12 and the switching Group III nitride transistor 11.

In some embodiments, the isolation region 40 is introduced into the Group III nitride substrate 20 which interrupts the two-dimensional charge gas 39 locally at a position which is laterally between the source sense finger 29' and the source finger 29. The isolation region 40 may extend through the heterojunction 25 so as to interrupt the two-dimensional charge gas 39 or may extend from the first major surface 26 into the Group III nitride body 20 by a depth such that its base is positioned within the Group III nitride channel layer 23 and such that it extends through the Group III nitride barrier layer 24 and heterojunction 25 and into the Group III nitride channel layer 23 in order to interrupt the two-dimensional charge gas 39.

In some embodiments, in order to electrically insulate the sense source finger 29' of the current sense Group III nitride transistor 12 from the source fingers 29 of the switching Group III nitride transistor device 11 and prevent resistance spreading, an isolation region 40 is introduced into the Group III nitride substrate 20 which interrupts the two-dimensional charge gas 39 locally at a position which is laterally between sense source finger 29' of the current sense Group III nitride transistor 12 and the sense fingers 29 of the switching Group III nitride transistor 11.

In some embodiments, the isolation region 40 has the form of a closed ring which laterally surrounds the current sense Group III nitride transistor device 12 and electrically insulates the current sense Group III nitride transistor device 12 from the switching Group III nitride transistor device 11. This enables the channel of the current sense transistor device 12 to be electrically insulated from the channel of the switching Group III nitride transistor device 11. Two electrically separate two-dimensional charge gases are formed; a two-dimensional charge gas in the first region of the Group III nitride body 20 which acts as the channel of the switching Group III nitride device 11 and a second two-dimensional charge gas in the second region of the Group III nitride body 20 which acts as the channel of the current sense Group III nitride device 11.

In some embodiments, the isolation region 40 comprises an implanted region which has a disrupted or damaged crystal structure. In some embodiments, the region 40 with the damaged crystal structure extends from the first major surface 26 into the Group III nitride substrate 20 by a distance such that such that it extends through the two-dimensional charge gas 39 formed at the interface 25 and locally interrupts the two-dimensional charge gas and divides it into two portions 39, 39' that are electrically isolated from one another. One portion 39 provides the channel of the switching Group III nitride transistor device 11 and the other portion 29' provides the channel of the current sense Group III nitride transistor device 11.

In other embodiments, the isolation region 40 comprises a trench which extends from the first major surface 26 into the Group III nitride substrate 20 by a distance such that its base is positioned within the channel layer 23 and such that its depth interrupts the two-dimensional charge gas 39 formed at the interface 25. The trench comprises electrically insulating material and may be entirely filled by electrically insulating material, for example silicon dioxide.

The electrical connection 35 between the sense drain finger 30' and active drain finger 30 and the electrical connection 36 between the sense gate finger 31' and the active gate finger 31 may each be formed by a portion of a metallisation structure which is deposited on the first major surface 26 of the Group III nitride substrate 20.

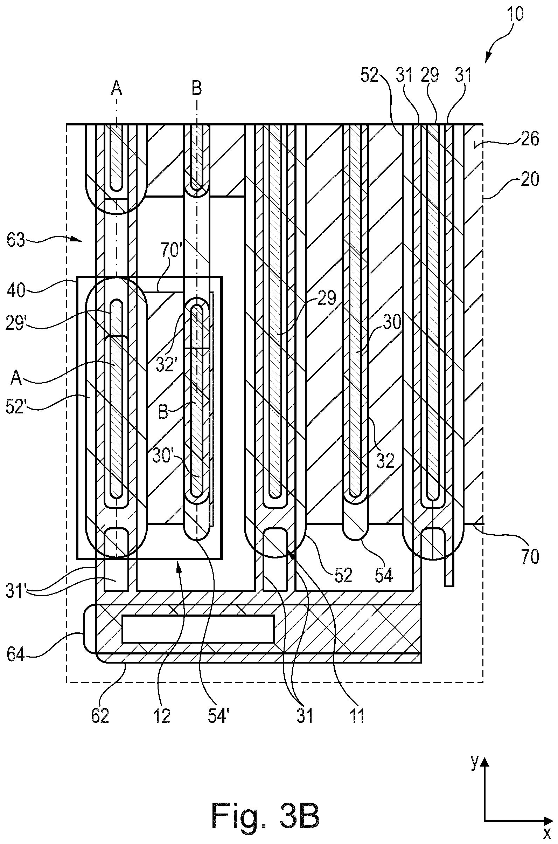

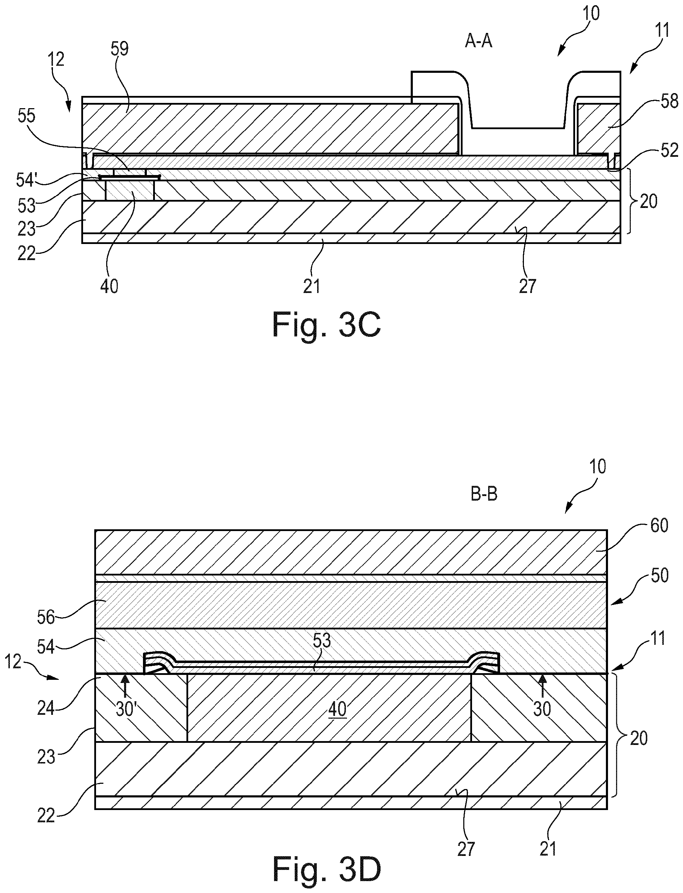

Figure 3, which includes figures 3A to 3D, illustrates the Group III nitride transistor device 10 and also the metallization structure 50, which provides the connections 35, 36, 37, 38 indicated schematically in figure 2 and which is arranged on the first major surface of the Group III nitride transistor device 10. Figure 3A illustrates a cross-sectional view of a portion of the Group III nitride transistor device 10 and the metallisation structure 50, Figure 3B illustrates a top view, Figure 3C a cross-sectional view along line A-A shown in figure 3B and Figure 3D a cross-sectional view of along the line B-B shown in figure 3B of the Group III nitride transistor device 10.

Referring to the cross-sectional view of figure 3A, the current sense Group III nitride transistor 12 includes a single transistor cell 28' which is laterally surrounded by an isolation structure 40 having the form of a closed ring that extends from the first major surface into the Group III nitride body and which has a depth such that it extends through the heterojunction 25 and interrupts the two-dimensional charge gas. Thus, the two-dimensional charge gas 39' of the current sense Group III nitride transistor device 12 is electrically separate from the two-dimensional charge gas 39 of the switching Group III nitride transistor 11.

The metallisation structure 50 includes an intermediate electrically conductive layer 51. The intermediate layer conductive layer 51 is arranged on a first electrically insulating layer 53 which is in turn arranged on the source fingers 29, drain fingers 30 and gate fingers 31 of the switching Group III nitride transistor 11 and on the sense source finger 29', sense drain finger 30' and sense gate finger 31' of the current sense Group III nitride transistor 12.

For each of the transistor cells 28 of the switching Group III nitride transistor device 11, the intermediate conductive layer 51 comprises a source finger 52 that is arranged on the electrically connected to the underlying source finger 29 arranged on the first major surface 26 by a via 64 that extends through an opening in the first electrically insulating layer 53. The intermediate source finger 52 has an elongate stripe-like shape and extends above and parallel to the source finger 29. The intermediate source finger 52 has lateral dimensions which are greater than the source finger 29 and extends over the gate finger 31. The intermediate source finger 52 is electrically insulated from the underlying gate finger 31 by the first electrically insulating layer 53. The intermediate conductive layer 51 further comprises, for each of the transistor cells 28 of the switching Group III nitride transistor 11, a drain finger 54 which is arranged on and electrically connected to the drain finger 30 arranged on the first major surface 26 by a via 64 that extends through an opening in the first electrically insulating layer 53. The intermediate drain finger 54 has an elongate stripe-like shape and extends above and parallel to the drain finger 30. The intermediate drain finger 54 has lateral dimensions which are greater than the drain finger 30 and is electrically spaced apart from the source finger 52 by a second electrically insulating layer 55. The intermediate source finger 52 and intermediate drain finger 54 are substantially coplanar. The second electrically insulating layer 55 is substantially coplanar with the electrically conductive layer 51.

For the transistor cell 28' of the current sense Group III nitride transistor device 12, the intermediate conductive layer 51 has a similar structure and comprises an elongate intermediate sense source finger 52' that is arranged above and electrically connected to the sense source finger 29' arranged on the first major surface 26 by a via 64'. The source finger 52' has lateral dimensions which are greater than the source finger 29' and extends over the sense gate finger 31'. The source finger 52' is electrically insulated from the underlying gate finger 31' by an electrically insulating layer 53. The intermediate conductive layer 51 further comprises an intermediate sense drain finger 54' which is arranged on and electrically connected to the drain finger 30' by a via 64' and which is electrically spaced apart from the intermediate sense source finger 52' by the electrically insulating layer 55.

A third electrically insulating layer 56 is arranged over the first conductive metallisation layer 51 and a third electrically conductive layer 57 is arranged on the third electrically insulating layer 56. The upper third conductive layer 57 comprises a first conductive area 58 which is electrically connected to the source fingers 52 and 29 and provides a source pad. The upper third conductive layer 57 comprises a second electrically conductive area 59 which is electrically connected to the source finger 52' and sense source finger 29'and which provides a current sense pad that is separate from the source pad. The upper third conductive layer 57 further comprises a third electrically conductive area 60 which is electrically connected to the drain fingers 30 of the switching Group III nitride transistor 11 and to the drain finger 30' of the current sense Group III nitride transistor 12 and provides a drain pad that is common to both the current sense and switching Group III nitride transistors 11, 12. The upper third conductive layer 57 also comprises a fourth electrically conductive area, which cannot be seen in the cross-sectional view of figure 3A but can be seen n the top view of figure 3B, that is electrically connected to the gate fingers 31 of the switching transistor device 11 and to the gate fingers 31' of the current sense transistor device 12

The first conductive area 58 is electrically connected to the source finger 52 by a conductive via 65 which extends through the electrically insulating layer 56 and the second conductive area 59 is electrically connected to the sense source finger 52' by a conductive via 65' which extends through the electrically insulating layer 56. The third conductive area 60 is electrically connected to the drain finger 54 by a via 65 which extends through the insulating layer 56 and is also electrically connected to the sense drain finger 54' as can be seen in the cross-sectional view of figure 3D.

Figure 3B illustrates a top view of a portion of the Group III nitride transistor device 10 and shows the single transistor cell 28' of the current sense Group III nitride transistor device 12 and some of the plurality of transistor cells 28 of the switching Group III nitride transistor device 11. Figure 3C illustrates a cross-sectional view of figure 3B along line A-A and Figure 3D illustrates a cross-sectional view of figure 3B along the line B-B.

Referring to the top view of figure 3B, the source fingers 29, drain fingers 30 and gate fingers 31 of the transistor cells 28 each have an elongate stripe-like form in plan view with a longest direction or length that extends in a longitudinal or Y direction, using the Cartesian coordinate system, and substantially parallel to one another. The source fingers 29, drain fingers 30 and gate fingers 31 are spaced apart from one another in the transverse or X direction, using the Cartesian coordinate system, with one gate finger arranged between neighbouring source and drain fingers 29, 30. In this embodiment, the transistor cells 28 have a common source arrangement with a gate finger 31 arranged on opposing sides of the source finger 29. The intermediate source fingers 52 and drain fingers 54 also extend in the Y direction and are positioned symmetrically above the source fingers 29 and drain fingers 30, respectively, of the underlying electrically conductive layer.

As can be seen in the top view of figure 3B and in the cross-sectional view of figure 3A, a gate finger 31 is arranged on two opposing sides of the source finger 29. The two gate fingers 31 are electrically connected to one another by a connection region 61 which is arranged adjacent and spaced apart from a lateral distal end of the source finger 29. The two gate fingers 31 are electrically connected to a gate runner 62 which is arranged on the first major surface 26 and which extends substantially perpendicularly to the length of the gate fingers 31 in the X direction. The gate runner 62 is spaced apart from the distal end of each of the source fingers 29 and drain fingers 30. The fourth conductive area 64 of the conductive layer 57 of the metallization structure 50 is electrically connected to the gate runner 62. The gate runner 62 forms the electrical connection 36 which is illustrated schematically in figure 2.

The top view of figure 3B also illustrates the single transistor cell 28' and the source finger 29', gate finger 31' and drain finger 30' of the current sense transistor device 12 arranged on the first major surface. The intermediate sense source finger 52' of the intermediate conductive layer 51 is arranged on and electrically connected to the source sense finger 29 and extends over but is electrically insulated from the sense gate finger 31'.

The sense transistor cell 28' is aligned with one of the transistor cells 28 of the switching Group III nitride transistor device 12. The sense drain finger 30' has a length which is aligned with the length of one of the drain fingers 30 of the switching Group III nitride transistor 11, i.e. aligned in the longitudinal or Y direction. Similarly, the source sense source finger 29' has a length which is aligned with the length of one of the source fingers 29 of the switching Group III nitride transistor 11.

The sense source finger 29' is laterally spaced apart from the source finger 29 in the longitudinal or Y direction by a gap 63. Similarly, the sense drain finger 30' is laterally spaced apart from the sense from the drain finger 30 of the switching Group III nitride transistor 11 by the gap 63. The position of the isolation region 40 is also shown in the top view of figure 3B and it can be seen that the isolation region 40 has a closed ring-shape in top view and laterally continuously surrounds the current sense Group III nitride transistor device 12. The isolation region 40 is positioned in the gap 63 between the sense source finger 29', 52' and the aligned source finger 29, 52 of the switching Group III nitride transistor 11 and between the sense drain finger 30' and the aligned drain finger 30 52 of the switching Group III nitride transistor 11.

The length of the sense source finger 29' and of the sense drain finger 30' is less than those of the majority of the transistor cells 28 and is also less that the length of the transistor cell 28 with which it is aligned. In contrast, the gate sense gate fingers 31' of the current sense Group III nitride transistor device 11 and the gate fingers 31 of the transistor cell 28 of the switching Group III nitride transistor 11 are integral and continuous with one another such that one pair of gate fingers 31 extending in the Y direction forms part of both the switching Group III nitride transistor 11 and the current sense Group III nitride transistor 12. This enables both the current sense Group III nitride transistor 12 and the switching Group III nitride transistor 11 to be switched by a common connection and voltage applied to the common gate runner 62.

As can be seen in figures 3B and 3C, the isolation region 40 electrically isolates the sense source finger 29' from the source finger 29 of the switching Group III nitride transistor 11 as it interrupts the two-dimensional charge gas. The second electrically insulating layer 55 is also arranged between and electrically insulates the intermediate sense source finger 52' from the intermediate source finger 52.

Referring to figures 3B and 3D, the isolation region 40 is also arranged between and separates the sense drain finger 30' from the drain finger 30 of the switching Group III nitride transistor device 11. However, the intermediate drain finger 54 formed in the metallization layer 51 is positioned on and electrically connected to the drain finger 30 of the switching Group III nitride transistor 11 and also to the sense drain finger 30' od the current sense Group III nitride transistor 12. The intermediate drain finger 54 is connected to the drain finger 30 by a via 64, extends from the drain finger 30, over the gap 63, over the isolation region 40 arranged in the gap 63, over the electrically insulating layer 53 and onto the sense drain finger 30' to which it is electrically connected by a further via 64'. Consequently, the sense drain finger 30' is electrically coupled to the drain finger 30 of the switching transistor device 11 by a portion of the metallisation structure 50 which is not in direct contact with the first major surface 26 of the Group III nitride body 20. The drain finger 54 that is common to both the current sense Group III nitride transistor 12 and the switching Group II nitride transistor 11 formed the connection shown schematically in figure 2. This drain connection is in contrast to the electrical connection between the gate fingers 31' of the current sense transistor 12 and the gate fingers 31 of the switching Group III nitride transistor 11 which are electrically connected by the common gate fingers in the lowermost conductive layer which is positioned on the first major surface 26.

Referring to the top view of figure 3B, the active area of the current sensing Group III nitride device 12 is indicated by the dashed line 70' and the active area of the switching Group III nitride transistor is indicated by the dashed line 70. It can be seen that the active area 70' of the current sense transistor device 12 is smaller than the area of the active area 70 of the switching Group III nitride transistor device 11 and it is the ratio of these areas that gives the desired K_{ILIS} ratio. The desired K_{ILIS} ratio. May also be provided by selecting the length of the sense source finger 29' and sense drain finger 30' and/or the number of sense transistor cells 28' in relation to the length of the source fingers 29 and drain fingers 30 and/or the number of active transistor cells 28.

Due to the isolation region 40 that surrounds the current sense Group III nitride transistor device 12 and which locally interrupts the two-dimensional charge gas in the isolation region, the two dimensional charge gas 39' of the current sense Group III nitride transistor 12 is electrically decoupled from the two dimensional charge gas 39 of the switching Group III nitride transistor device 11, thus providing a Group III nitride transistor device 10 with integrated current sensing and an actual K_{ILIS} ratio that is more closely matched to the K_{ILIS} ratio expected when considering the relative dimensions of the switching Group III nitride transistor device 11 and the current sense Group III nitride transistor 12.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A Group III nitride transistor device, comprising:
a Group III nitride-based semiconductor body comprising a Group III nitride barrier layer arranged on a Group III nitride channel layer and forming a heterojunction therebetween capable of supporting a two-dimensional charge gas;
a switching Group III nitride transistor device and a current sense Group III nitride transistor device formed in the Group III nitride-based semiconductor body;
wherein the current sense Group III nitride-based transistor device is electrically insulated from the switching Group III nitride transistor device by local interruption of the two-dimensional charge gas.

2. A Group III nitride transistor device according to claim 1, wherein the two-dimensional charge gas is locally interrupted by an isolation region.

3. A Group III nitride transistor device according to claim 1 or claim 2, wherein the isolation region has the form of a closed ring that laterally surrounds the current sense Group III nitride transistor device.

4. A Group III nitride transistor device according to claim 2 or claim 3, wherein the Group III nitride-based semiconductor body comprises a first major surface and the isolation region comprises an implanted region or the isolation region comprises a trench extending into the first surface and comprising insulating material.

5. A Group III nitride transistor device according to any one of claims 1 to 4,
wherein the isolation region has a depth from the first surface that is greater than a depth of the heterojunction from the first surface.

6. A Group III nitride transistor device according to any one of claims 1 to 5,
wherein the switching Group III nitride transistor device comprises a plurality of active transistor cells, each active transistor cell comprising a source finger, a gate finger and a drain finger on the first surface, the gate finger being laterally positioned between the source finger and the drain finger,
wherein the current sense Group III nitride transistor device comprises at least one sense transistor cell, each sense transistor cell comprising sense source finger, a sense gate finger and a second drain finger on the first surface, the sense gate finger being laterally positioned between the sense source finger and the sense drain finger.

7. A Group III nitride transistor device according to claim 6, wherein the sense source finger has a length that is aligned with a length of one of the source fingers of the plurality of active transistor cells and is spaced apart from that source finger by a first gap and a portion of the isolation region is positioned in the first gap.

8. A Group III nitride transistor device according to claim 6 or claim 7, further comprising a source metallization finger arranged on the source finger of each active transistor cell and a sense source metallization finger arranged on the sense source finger, wherein the source metallization fingers and the sense source metallization finger are spaced apart and electrically insulated from one another.

9. A Group III nitride transistor device according to any one of claims 6 to 8,
wherein the sense gate finger is integral with one of the gate fingers of the plurality of transistor cells of the switching Group III nitride transistor device.

10. A Group III nitride transistor device according to any one of claims 6 to 9,
wherein the sense drain finger has a length that is aligned with a length of one of the drain fingers of the plurality of transistor cells and spaced apart from that drain finger by a second gap and a portion of the isolation region is positioned in the second gap.

11. A Group III nitride transistor device according to claim 10, wherein sense drain finger is electrically connected to a drain finger of the plurality of transistor active cells of the switching Group III nitride transistor device by a drain metallization finger that extends over the second gap.

12. A Group III nitride transistor device according to claim 11, wherein the drain metallization finger is arranged on and extends between one of the drain fingers of the plurality of transistor active cells of the switching Group III nitride transistor device and the sense drain finger.

13. A Group III nitride transistor device according to claim 11 or claim 12, further comprising a source pad, a drain pad, a gate pad and a current sense pad, wherein
the source fingers of the switching Group III nitride transistor device are electrically coupled to the source pad,
the sense source fingers of the current sense Group III nitride transistor device are electrically coupled to the current sense pad,
the gate fingers of the switching Group III nitride transistor device and the sense gate fingers of the current sense Group III nitride transistor device are electrically coupled to the gate pad,
the drain fingers of the switching Group III nitride transistor device and the sense drain fingers of the current sense Group III nitride transistor device are electrically coupled to the drain pad.

14. A Group III nitride transistor device according to any one of claims 1 to 14,
wherein the current ratio between the switching Group III nitride transistor and the current sense Group III nitride transistor (KILIS) is 5000 or more, or 10000 or more.

15. A Group III nitride transistor device according to claim 14, wherein the current sense Group III nitride transistor device comprises a single sense source finger, a single sense gate finger and a single sense gate finger and the length of the sense source finger and sense drain finger is selected so as to provide a current ratio of 5000 or more, or 10000 or more.
